# EUROPEAN PATENT APPLICATION

(11) **EP 4 586 315 A1**
(43) Date of publication of application: **16.07.2025**
(21) Application number: 24205804.8
(22) Date of filing: 10.10.2024
(51) Int. Cl.: H01L 23/64, H01L 23/66, H01L 23/522, H01L 25/065, H01L 25/07, H01L 25/075, H02M 3/156, H02M 3/158

(54) **VERTICAL POWER DELIVERY IN SPACE-CONSTRAINED SYSTEM-ON-PACKAGE**

(30) Priority: 12.01.2024 US 202418411955
(71) Applicant: INTEL Corporation, Santa Clara, CA 95054 (US)
(72) Inventor: JAIN, Rinkle, Sherwood, 97140 (US); XU, Shunjiang, Milpitas, 95035 (US); DOUGLAS, Jonathan, Cave Creek, 85331 (US); SCHAEF, Christopher, San Diego, 92127 (US); KAUSHAL, Rajiv, Portland, 97229 (US)
(74) Representative: Viering, Jentschura & Partner mbB Patent- und Rechtsanwälte

(57) **Abstract**

Embodiments herein relate to a semiconductor device which includes one or more voltage regulator (VR) chiplets coupled to a package interposer, where the package interposer includes coaxial magnetic composite core inductors to provide power to one or more load die. In one possible configuration, the one or more VR chiplets are coupled to the bottom side of the package interposer, the bottom side of the package interposer is coupled to the top side of a motherboard, and the one or more load die are coupled to the top side of the package interposer. In another possible configuration, the one or more VR chiplets are coupled to the bottom side of the package interposer, the top side of the package interposer is coupled to the bottom side of a motherboard and the one or more load die are coupled to the top side of the motherboard.

## Description

### BACKGROUND

Computing devices often rely on voltage regulators (VRs) to obtain power. For example, direct current (DC)-to-DC voltage regulators can convert a power supply at one DC voltage to another, typically lower DC voltage. A voltage regulator can convert the main supply voltage of a computing device, such as 12-48 V, down to lower voltages, such as about 1-2 V. The lower voltages can be used by various components in the computing device, such as a Universal Serial Bus (USB) interface, memory such as dynamic random access memory (DRAM) and processing resources such as a central processing unit (CPU). However, various challenges are encountered in designing voltage regulators in a space-constrained system.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
FIG. 1 depicts a plan view of an example high-performance graphics system-on-package (SoP) 100, in accordance with various embodiments.
FIG. 2A depicts a profile view of an example semiconductor device 200 which includes a SoP 210 coupled to top sides 220t1 and 220t2 of a motherboard 220, in accordance with various embodiments.
FIG. 2B depicts a planar view of the motherboard 220 of FIG. 2A, showing a cutout region 221 for the VR chiplet 230, in accordance with various embodiments.
FIG. 3 depicts a profile view of an example semiconductor device 300 which includes a first SoP 310 coupled to a top side 320t of a motherboard 320, and a second SoP 330 coupled to a bottom side 320b of the motherboard, where the second SoP includes one or an array of VR chiplets 332 associated with a set of inductors 342 in a package interposer 340, in accordance with various embodiments.
FIG. 4 depicts a profile view of an example semiconductor device 400 which includes a first SoP 410 coupled to a top side 420t of a motherboard 420, and a second SoP 430 coupled to a bottom side 420b of the motherboard, where the second SoP includes VR chiplets 432 and 434 associated with sets of inductors 442 and 444, respectively, in accordance with various embodiments.
FIG. 5A depicts an example view of a subset 240s of the package interposer 240 of FIG. 2A including example inductors of the set of inductors 242 as coaxial magnetic composite core inductors in a single-pass configuration, in accordance with various embodiments.
FIG. 5B depicts an example cross-sectional view of the inductor 501 in FIG. 5A, in accordance with various embodiments.
FIG. 5C depicts an example view of the subset 240s of the package interposer 240 of FIG. 2A including example inductors in the set of inductors 242 in a three-pass configuration, in accordance with various embodiments.
FIG. 6 depicts an example implementation of the SoP 210 of FIG. 2A, in accordance with various embodiments.
FIG. 7 depicts an example implementation of the control circuit 650 of FIG. 6, in accordance with various embodiments.
FIG. 8 depicts an example plot of net efficiency versus load current for the VR chiplet 230 of FIG. 2A, in accordance with various embodiments.
FIG. 9 depicts example plots of efficiency (plot 900) and load current distribution (plots 910 and 920) versus total load current for the VR chiplets 432 and 434 of FIG. 4, in accordance with various embodiments.
FIG. 10 illustrates an example of components that may be present in a computing system 1050 for implementing the techniques (e.g., operations, processes, methods, and methodologies) described herein.

### DETAILED DESCRIPTION

As mentioned at the outset, various challenges are encountered in designing voltage regulators in a space-constrained system.

A System on Package (SoP) for supercomputer and artificial intelligence applications, for instance, require hundreds of amperes of current. A SoP refers to an advanced packaging technology used in electronic systems and integrated circuits. In a SoP, multiple chips or dies, e.g., chiplets, are integrated into a single package. The package can include, e.g., a processor die, a memory die and/or a communication interface die. The package can include a system-on-a-chip (SoC), which integrates multiple components, such as processors, memory, and other functional blocks into a single chip or chiplet. These components all require power to operate. In another approach, multiple integrated circuits are provided within the same package, such as in stacked tile/chiplet designs.

However, the entire periphery of a SoC in the SoP is typically already used for memory and input/output (IO) routing. Moreover, the SoP is also highly constrained in x, y and z dimensions due to extensive cooling requirements. Vertical power delivery is warranted for both form-factor fit and efficiency. Conventional solutions cannot be used due to limited z-height from the cooling needs of these systems. High power density voltage regulators (VRs) provide a low profile solution that is compatible with the cooling needs.

One approach involves using discrete VRs that use discrete field-effect transistors (FETs) and passive components that switch at ~600 KHz to deliver high currents. However, the footprint of these VRs far exceeds that of the SoP. As a result, bulky inductors and capacitors are used outside the SoP, on the motherboard. At the same time, these are also tall components that are incompatible with cooling hardware, which is a critical bottleneck in high-power systems.

In these approaches, power delivery is done laterally, with the VR arranged to the side of the load die receiving power, and is constrained by large voltage domains encompassing multiple compute, memory and IO chiplets. This approach incurs a power penalty from guard banding needed by inter-die Vmin variations of the process, as well as high distribution losses. This is typically not a feasible approach for systems exceeding 750 W, for instance, due to exorbitant losses.

The solutions provided herein address the above and other disadvantages. In one aspect, the solution provides architectural modifications to a fully-integrated voltage regulator (FIVR) to allow up to 40x higher current capability, for instance, for each VR chiplet, while also enabling a very compact solution. The current capability can be increased even further by increasing the number of VR chiplets.

The solutions can include one or more VR chiplets which are coupled, e.g., attached, to a package, e.g., interposer or package interposer, which includes inductors such as coaxial magnetic composite core inductors (coax MILs). Coax MIL is one possible inductor technology but there could also be other inductor types embedded in the package core. The coaxial MIL inductors could be replaced with other embedded inductors. An interposer can refer to, e.g., a structure in an integrated circuit (IC) package between two or more chips or dies that provides routing for signals and/or power distribution between the two or more chips or dies. In some cases, the interposer is used to physically hold the two or more chips or dies together. In some cases, the interposer includes passive devices but not active devices. In some cases, the interposer is made from silicon, glass, or an organic substrate.

The VR chiplet may have any topology, including a capacitive converter topology.

The one or more VR chiplets provide power to one or more load die via the inductors of the package interposer. In one possible configuration, the one or more VR chiplets are coupled to the bottom side of the package interposer, the bottom side of the package interposer is coupled to the top side of a motherboard, and the one or more load die are coupled to the top side of the package interposer. In another possible configuration, the one or more VR chiplets are coupled to the bottom side of a dedicated package interposer, the top side of the package interposer is coupled to the bottom side of a motherboard and the one or more load die are coupled to the top side of the motherboard.

The coax MILs can thus be built in the core of the package interposer, under the shadow or footprint of the one or more load die. The resulting SoP is compact and provides a significant current capacity and conversion efficiency with a multi-kW capability with hundreds of amperes of current output.

In another aspect, when multiple VR chiplets are used in parallel or ganged, each VR chiplet can include control circuitry to equalize its output current with the one or more other VR chiplets. Or, the output current can be provided at a prescribed ratio relative to the output current of the one or more other VR chiplets.

Additionally, the inductors can be used in a single-pass mode for vertical power delivery, from the one or more VR chiplets to the one or more load die. In this approach, each inductor is coupled at one side of the package interposer to a VR chiplet and at the other, opposing side of the package interposer to the one or more load die, so that current travels in one direction through the package interposer. Or, more generally, a current path can pass through the package interposer an odd number of times, e.g., 1, 3, ...

The solutions provide a number of advantages, including one or more orders of magnitude higher volume current density than standard or custom discrete solutions. Additionally, the solutions enable vertical power delivery that is constrained in x,y,z directions. Further, passives can be contained within the die footprint. The solutions are compact for compatibility with existing cooling components. The solutions do not require custom cutouts in universal base boards, allowing easy adoption due to compatibility with the standard datacenter infrastructure. The solutions reduce costs, and capacitor needs are also reduced due to high switching frequency/bandwidth. High costs for embedded deep trench capacitors can be avoided. Net power consumption can be up to 10% or more below that of conventional solutions at iso performance.

These and other features will be further apparent in view of the following discussion.

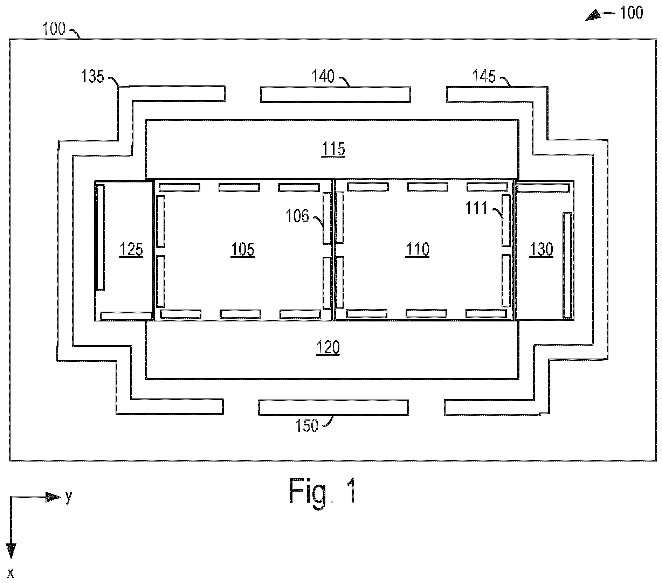

FIG. 1 depicts a plan view of an example high-performance graphics system-on-package (SoP) 100, in accordance with various embodiments. The SoP includes two tiles 105 and 110 which can be part of a SoC. Each tile includes IO areas around its periphery, such as IO areas 106 and 111 for tiles 105 and 110, respectively. High-bandwidth memories 115 and 120 are provided on opposing sides of the tiles, while IO areas 125 and 130 are also provided on opposing sides of the tiles. Package capacitors are provided along the periphery of the package such as in regions 135, 140, 145 and 150. Accordingly, as mentioned, there is little or no room for receiving power laterally or peripherally from a VR. The solutions provided herein address this issue with a vertical power delivery configuration, where power is delivered to one or more load die from below (or above) the load die.

An x-y-x coordinate system is depicted in various figures for reference, where z denotes the vertical direction.

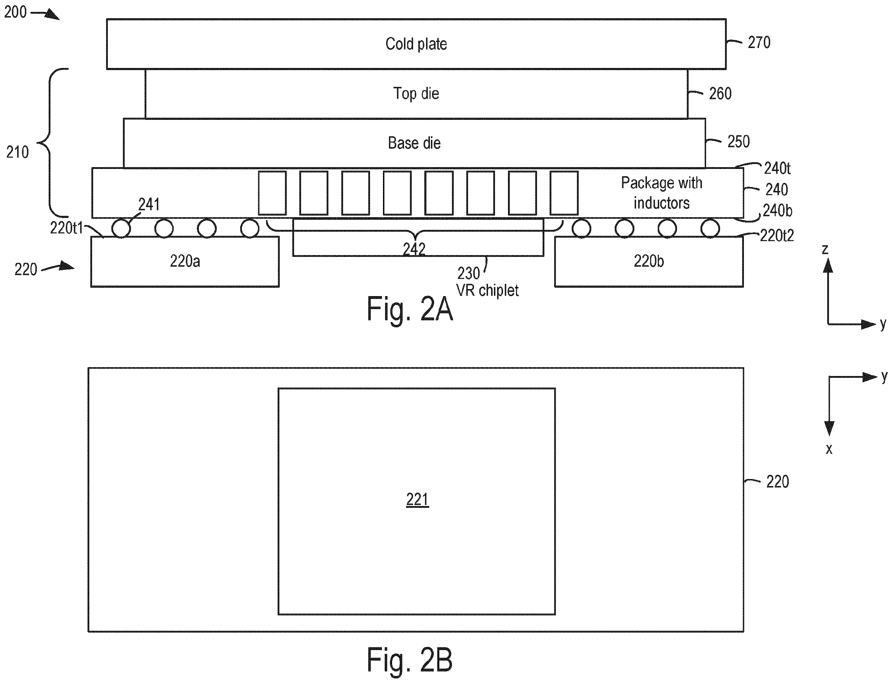

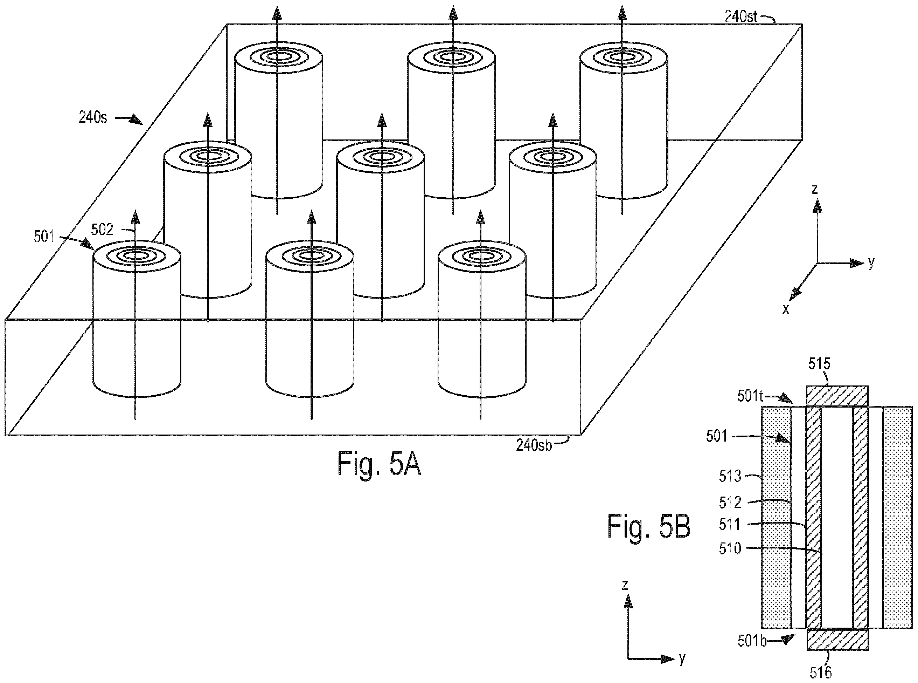

FIG. 2A depicts a profile view of an example semiconductor device 200 which includes a SoP 210 coupled to top sides 220t1 and 220t2 of a motherboard 220, in accordance with various embodiments. The SoP 210 includes a package interposer 240 having a set of inductors 242. The package interposer can be a glass-reinforced epoxy laminate material such as FR-4. FR4 is a National Electrical Manufacturers Association (NEMA) grade designation for glass-reinforced epoxy laminate material. FR-4 is a composite material composed of woven fiberglass cloth with an epoxy resin binder that is flame resistant. The package interposer 240 can be coupled at its bottom side 240b to the top side 220t1 and 220t2 of the motherboard 220 or other printed circuit board (PCB), for instance. The attachment can be made by a ball grid array 241 denoted by circles. This is referred to as a land side attachment of the package interposer to the motherboard using the bottom or land side of the package interposer. The inductors can be coax MILs, as mentioned, in one approach. See also FIGs. 5A-5C.

The motherboard 220 is depicted by regions 220a and 220b which surround a cutoff region 221 (FIG. 2B) which provides room for the VR chiplet 230 on the bottom side 240b of the package interposer 240. In another option, the cutout in the board does not exist and, alternatively, the VR chiplet 230 could sit between the motherboard and the package. In this configuration, there may or may not be a thermal interface between the VR chiplet and the motherboard.

A base die 250 is coupled to the top side 240t of the package interposer 240, and a top die 260 is coupled to the base die. The base die and top die are examples of load dies which receive power from the VR chiplet 230. Generally, one or more load die may be positioned above the package interposer in the SoP. A cold plate 270 is coupled to the top side of the top die, which is also a top side of the SoP. The cold plate dissipates heat from the SoP by transferring it through a liquid loop to a cooling device such as a radiator.

The base die may be coupled directly to the package interposer using package capacitors. Similarly, the top die may be coupled directly to the base die.

In the examples of FIGs. 2, 3 and 4, each inductor comprises a first end at a first side of the package interposer and a second end, opposite the first end, at a second side of the package interposer, the first side faces the plurality of VR chiplets and the second side faces the load die.

FIG. 2B depicts a planar view of the motherboard 220 of FIG. 2A, showing a cutout region 221 for the VR chiplet 230, in accordance with various embodiments. As mentioned, the cutout region 221 of the motherboard 220 can be provided through which the VR chiplet 230 extends when the package interposer is coupled to the motherboard. This helps achieve a compact design with a minimal height.

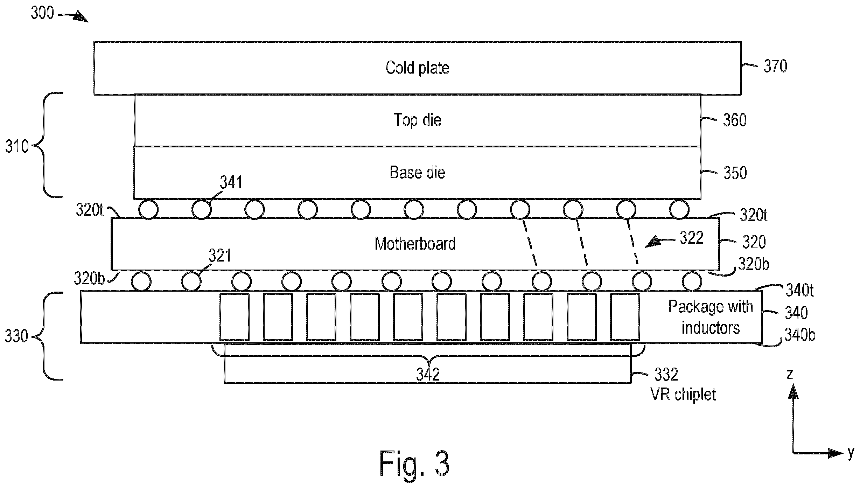

FIG. 3 depicts a profile view of an example semiconductor device 300 which includes a first SoP 310 coupled to a top side 320t of a motherboard 320, and a second SoP 330 coupled to a bottom side 320b of the motherboard, where the second SoP includes one or an array of VR chiplets 332 associated with a set of inductors 342 in a package interposer 340, in accordance with various embodiments.

The first SoP 310 includes a base die 350 coupled to a top side 320t of a motherboard 320 via a ball grid array 341, and a top die 360 coupled to the top side of the base die. A cold plate 370 is provided on top of the top die and the first SoP 310.

The second SoP 330 includes the VR chiplet 332 coupled to the bottom side 340b of the package interposer 340. A top side 340t of the package interposer is coupled to a bottom side 320b or underside of the motherboard via a ball grid array 321. The package interposer 340 includes a set of inductors 342. The motherboard includes example conductive paths 322 which couple power from the inductors to the base die and/or top die via the ball grid arrays 321 and 341, in one possible approach.

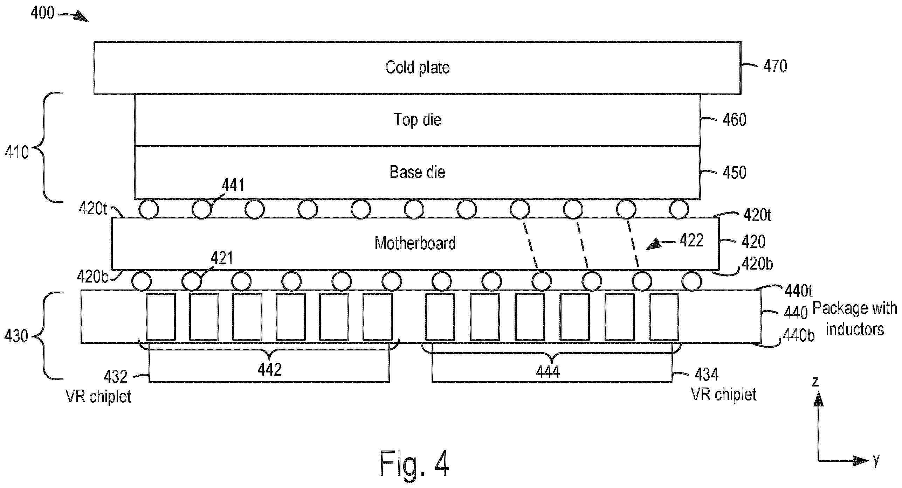

FIG. 4 depicts a profile view of an example semiconductor device 400 which includes a first SoP 410 coupled to a top side 420t of a motherboard 420, and a second SoP 430 coupled to a bottom side 420b of the motherboard, where the second SoP includes first and second VR chiplets 432 and 434, respectively, associated with first and second sets of inductors 442 and 444, respectively, in accordance with various embodiments. The VR chiplets 432 and 434 are an example of a plurality of chiplets arranged laterally on the package interposer 440. As mentioned, multiple VR chiplets can be used in a SoP to increase the power delivered to one or more load die. This example includes two VR chiplets 432 and 434, but more than two can be used. The VR chiplet 434 is an example of another chiplet relative to the VR chiplet 432.

The first SoP 410 includes a base die 450 coupled to a top side 420t of a motherboard 420 via a ball grid array 441, and a top die 460 coupled to the top of the base die. A cold plate 470 is provided on top of the top die and the first SoP 410.

The second SoP 430 includes the VR chiplets 432 and 434 coupled to the bottom side 440b of the package interposer 440. A top side 440t of the package interposer is coupled to a bottom side 420b or underside of the motherboard via a ball grid array 421. The package interposer 440 includes a first respective set of inductors 442 used by the first VR chiplet 432, and a second respective set of inductors 444 used by the second VR chiplet 434. The motherboard includes example conductive paths 422 which couple power from the inductors to the base die and/or top die via the ball grid arrays 421 and 441, in one possible approach.

FIG. 5A depicts an example view of a subset 240s of the package interposer 240 of FIG. 2A including example inductors of the set of inductors 242 as coaxial magnetic composite core inductors in a single-pass configuration, in accordance with various embodiments. The example also applies to the package interposers 340 and 440 of FIGs. 3 and 4, respectively. The inductors may be arranged in a grid in the x-y plane, for example. Each inductor has a post or cylinder shape and extends from a bottom side 240sb to a top side 240st of the subset 240s of the package interposer 240. Additionally, an arrow which passes through each inductor in the z direction indicates a current path through the inductor. In this example, the current flows through each inductor in the same direction: the upward or z direction. Each current path includes a single-pass through the package interposer. An example inductor 501 with a current path 502 is depicted.

Each inductor can be connected to a VR chiplet at a first end to receive a current, e.g., via a bridge, and to one or more load die at a second end, opposite the first end, to provide the current to one or more load die, e.g., via a power delivery network.

FIG. 5B depicts an example cross-sectional view of the inductor 501 in FIG. 5A, in accordance with various embodiments. The cross-section is in the y-z plane. When the inductor is fabricated, a through-hole is made in the package interposer, and the walls of the through-hole are plated with metal such as copper to provide a metal layer 511 in the shape of a hollow cylinder, for example. A remaining void in the through-hole is then filled with a dielectric material 510 in the shape of a post. The dielectric material forms a dielectric core within the metal cylinder 511. A composite magnetic material 512 is provided which encapsulates the metal layer. The composite magnetic material may also be in the shape of a hollow cylinder. The composite magnetic material may comprise an epoxy composite with magnetic fillers such as magnetic particles (e.g., ferrites, iron alloys and/or cobalt) distributed in the epoxy.

A region 513 between inductors in the package interposer includes a dielectric material.

Contacts 515 and 516 can be provided at the top side 501t and bottom side 501b of the inductor 501, coupled to the metal cylinder 511.

The inductor is coaxial since a central longitudinal axis of the metal cylinder 511511 is the same as a central longitudinal axis of the composite magnetic material 512.

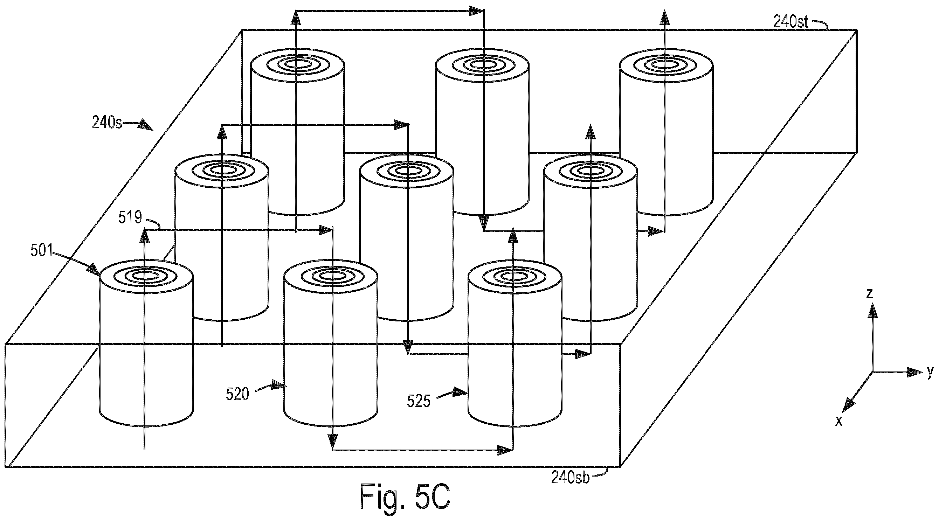

FIG. 5C depicts an example view of the subset 240s of the package interposer 240 of FIG. 2A including example inductors in the set of inductors 242 in a three-pass configuration, in accordance with various embodiments. In this configuration, each current path passes through the subset 240s of the package interposer 240 three times. For example, refer to the current path 519 which passes through inductors 501, 520 and 525. The current path passes upwards through the inductor 501, then horizontally in the y direction at the top side 240st, then downwards through the inductor 520, then horizontally in the y direction at the bottom side 240sb, then upwards through the inductor 525. This configuration increases the available inductance without increasing the height of the package interposer layer.

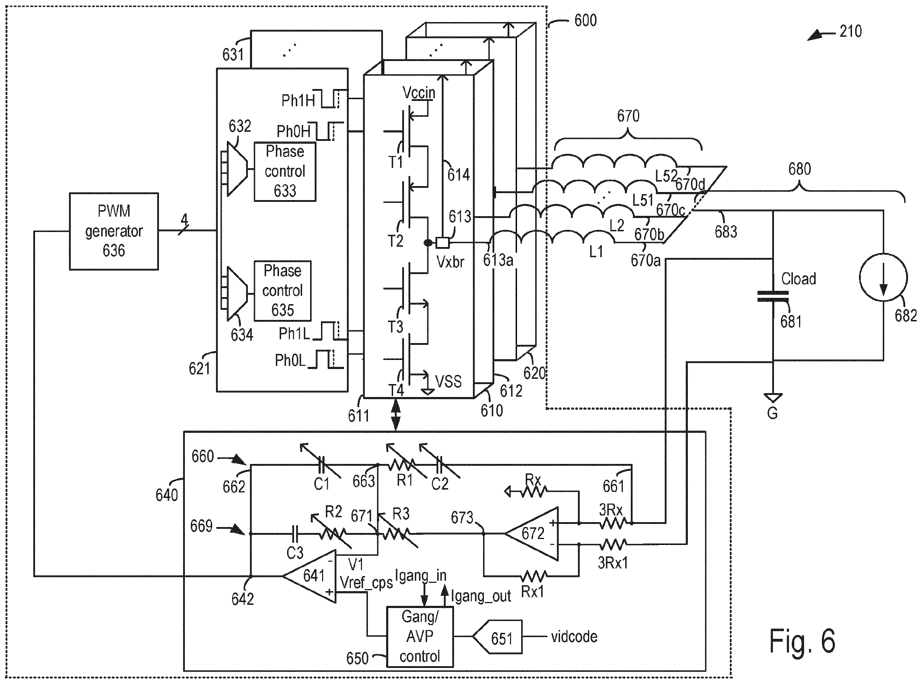

FIG. 6 depicts an example implementation of the SoP 210 of FIG. 2A, in accordance with various embodiments. The SoP 210 includes a switching VR 600 which is part of, e.g., the VR chiplets 230, 332, 432 or 434, a set of inductors 670 representing, e.g., one of the sets of inductors 242, 342, 442 or 444, and a load capacitor 681 and a load current 682, which may be part of a load die 680, representing a base die and/or a top die. The VR 600 includes a plurality of powertrains which may be arranged in pairs 610, ..., 620, for example. An example pair 610 includes powertrains 611 and 612. Each powertrain includes a set of transistors coupled in series, such as transistors T1, T2, T3 and T4. T1 and T2 may be p-type metal-oxide-semiconductor field-effect transistor (MOSFETs) while T3 and T4 are n-type MOSFETs, for example. T2 and T3 are high-side and low-side transistors which are alternately switched on and off to provide a voltage Vxbr and associated current at a respective output node 613. Each powertrain is similarly configured and has a respective output node. The output node 613 is coupled to an input end 613a of a respective inductor L1. T1 and T4 are power and ground isolation transistors, respectively.

The inductor L1 is in the set of inductors 670 which includes inductors L1, L2,..., L51, L52. In this example, there are 52 powertrains and 52 respective inductors. Each inductor has its input end coupled to the output node of the respective powertrain and its output end 670a, 670b, ..., 670c, 670d coupled to a node 683 at the load die where the output currents are combined for delivery to the circuits of the load die. The sensed current of the powertrains can be fed back to a compensator circuit 640 for regulation via respective feedback paths, such as the feedback path 614 of the powertrain 611. The output voltage of the node 683 can also be fed back to the compensator circuit 640 for regulation.

Each pair of powertrains 610, ..., 620 is driven by a drive circuit 621, ..., 631, respectively, in response to clock signals from a pulse-width modulation (PWM) clock generator 636. For example, the PWM generator can provide four clock signals with different phases to multiplexers 632 and 634 of the drive circuit 621, and to corresponding multiplexers of the other drive circuits. A phase control circuit 633 selects two of the clock signals, and provides a delay which is specific to the pair of powertrains 610, to provide signals Ph0H and Ph1H, and the phase control circuit 635 selects the other two clock signals and provides the delay which is specific to the pair of powertrains 610, to provide signals Ph0L and Ph1L. Ph0H and Ph1H are used to drive the control gates of the high-side transistors in the powertrains 611 and 612, respectively. Similarly, Ph0L and Ph1L are used to drive the control gates of the low-side transistors in the powertrains 611 and 612, respectively. As depicted, Ph1H is delayed relative to Ph0H, and Ph1L is delayed relative to Ph0L. Additionally, Ph0H is antiphase with Ph0L, and Ph1H is antiphase with Ph1L. In this example, the control gate voltage of the high-side transistor is high or low when the control gate voltage of the low-side transistor is low or high, respectively.

The other drive circuits can be configured analogously. For example, a second drive circuit can provide a delay which is specific to a second pair of powertrains to provide signals Ph2H, Ph2L, Ph3H and Ph3L, which are delayed relative to Ph0H, Ph0L, Ph1H and Ph1L, respectively, and so forth. In this manner, the powertrains are driven with PWM signals which are offset or staggered relative to one another to help provide a continuous and stable current output at the node 683.

The PWM generator is controlled by an output at a node 642 from a comparator 641 in the compensator circuit 640. The output instructs the PWM generator to turn on or off to regulate a voltage across Cload, e.g., the voltage at the node 683. The comparator 641 has a non-inverting input (+) coupled to a reference voltage, Vref_cps, which is provided by a gang/AVP control circuit 650, and an inverting input (-) coupled to a voltage, V1, which is based on a voltage of the load. The control circuit 650 is responsive to a voltage output from a digital-to-analog converter (DAC) 651. The voltage is based on a voltage identification code, vidcode, which is a requested voltage output of the VR. Vidcode can be set by a processor or other circuit on the one or more load die, for example.

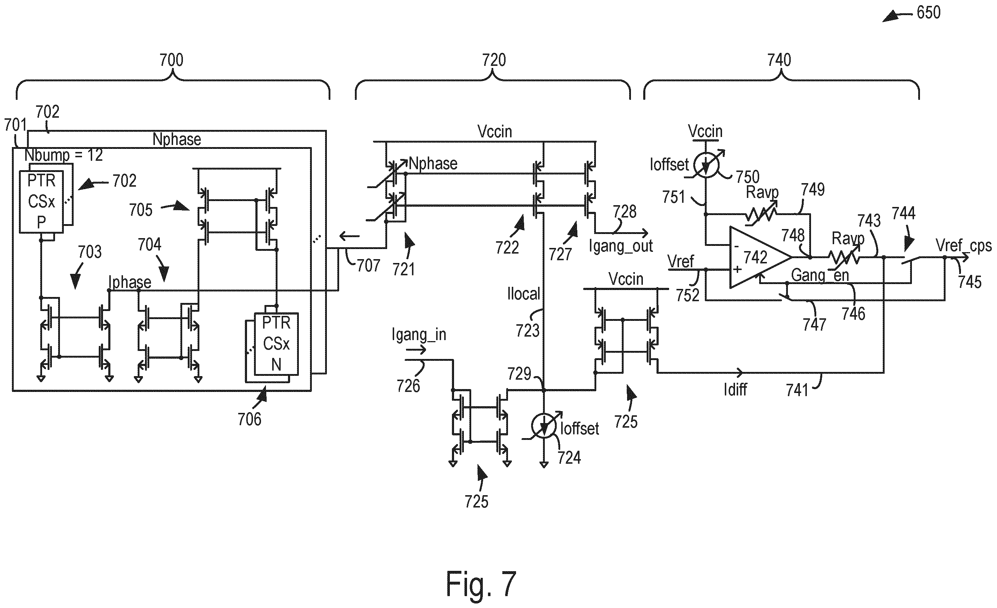

The control circuit 650 is also responsive to a current, Igang, which represents a current output from another VR chiplet in the SoP. For example, the switching voltage regulator 600 may be in the VR chiplet 432 of FIG. 4 (the local VR chiplet) while Igang is a current output of the VR chiplet 434 (another VR chiplet). Generally, the control circuit 650 receives Igang from each of one or more other VR chiplets in the SoP. The control circuit can adjust Vref_cps to equalize the output current of the local VR chiplet with that of the one or more other VR chiplets in the SoP, or to provide the output current of the local VR chiplet at a prescribed ratio of the current output of the one or more other VR chiplets. The control circuit 650 can similarly provide Igang_out to the one or more other VR chiplets in the SoP to indicate the output current of the local VR chiplet and its switching voltage regulator. See also FIG. 7.

V1 is provided by circuitry which includes a first path 660 and a second path 669. The first path includes in sequence, an adjustable capacitor C1, a node 663, an adjustable resistor R1 and another adjustable capacitor C2. The first path 660 is coupled at one end 661 to the node 683 and at the other end 662 to the node 642.

The second path 669 includes in sequence a capacitor C3, an adjustable resistor R2, a node 671, and another adjustable resistor R3. An amplifier 672 provides an output on a node 673 based on its inputs. A non-inverting input (+) of the amplifier 672 is coupled to ground via a resistor Rx and to the node 683 via a resistor 3Rx. An inverting input (-) of the amplifier 672 is coupled to the node 673 via a resistor Rx1 in a feedforward path, and to ground (G) via a resistor 3Rx1.

The non-inverting input of the comparator 641 is coupled to the node 671 which in turn is coupled to the node 663.

The switching voltage regulator can be a buck converter, in an example implementation, although other types of VRs can be used as well.

FIG. 7 depicts an example implementation of the control circuit 650 of FIG. 6, in accordance with various embodiments. As mentioned, the control circuit 650 receives Igang_in from one or more other VR chiplets and outputs Igang_out to the one or more other VR chiplets. The control circuit includes a current sensing circuit 700, a receiver 720 and a Vref generation circuit 740. The sensing circuit 700 includes a number of circuits 701, ..., 702 for sensing current which is output by the powertrains. The circuit 701 includes a set of powertrain current sensors 702, current mirror 703 with a ratio of Nbump: 1, a current mirror 704 with a ratio of 1:1, and a current mirror 705 with a ratio of 1:Nbump. An additional set of current sensors 706 sense the output current from the current mirror 705. The sensed current from each circuit 701, ..., 702 is combined at a node 707 and provided to the receiver 720.

The receiver 720 includes transistors 721 and 722 which provide a local current, Ilocal, on a path 723. The path 723 is coupled to a current source 724 which provides an offset current, Ioffset. The node 729 is coupled to the output of a 4:1 current mirror 725 which receives Igang_in as an input at a node 726, and provides a scaled down version of Igang_in at the node 729. The transistors 722 and 727 provide a 1:4 current mirror which outputs Igang_out on a node 728.

The node 729 is coupled to a 1:1 current mirror 725 which output a differential current, Idiff=Igang_in_scaled - Ilocal _ Ioffset, on a path 741 in the Vref generation circuit 740. Igang_in_scaled is a scaled down version of Igang, e.g., scaled down to one-fourth of Igang_in. Idiff modulates a voltage which is output by an amplifier 742 on a node 743, after the output at a node 748 passes through an adjustable resistor Ravp. AVP refers to an adjustable voltage position for a voltage regulator. The node 743 is coupled to an output node 745 of the Vref generation circuit 740, which provides the output voltage Vref_cps to the comparator 641 in FIG. 6. The switch is controlled by an enable signal Gang_en on a path 746. The switch is closed (conductive) when ganging of multiple VR chiplets is enabled. If ganging is disabled, an initial reference voltage Vref is passed to the output node 745 on a switched path 747. The output node 748 is coupled via a path 749 and a resistor Ravp to a current source 750 which provides the current Ioffset on a path 751. The path 751 is coupled to an inverting input (-) of the amplifier 742 and Vref at the node 752 is coupled to the non-inverting input (+) of the amplifier.

The control circuit 650 thus has the ability to adjust Vref based on the current output of one or more other VR chiplets in the same SoP, and coupled to the same package interposer.

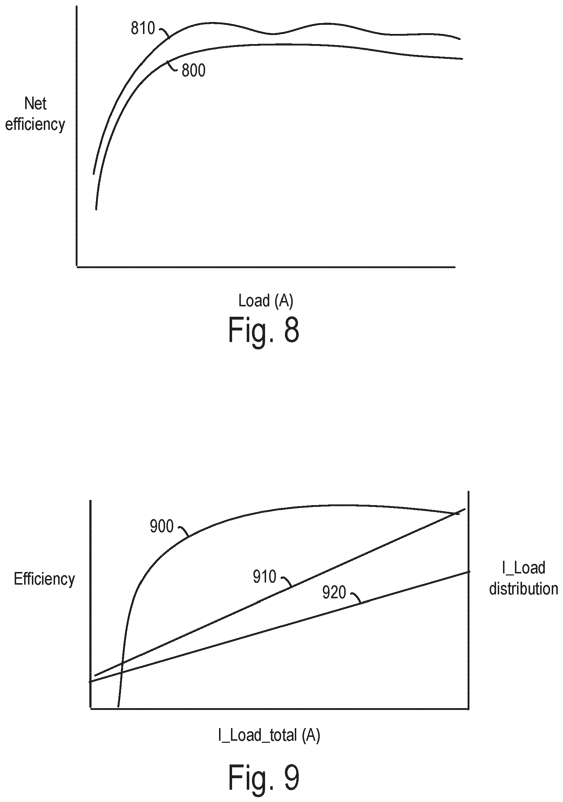

FIG. 8 depicts an example plot of net efficiency versus load current for the VR chiplet 230 of FIG. 2A, in accordance with various embodiments. The data is for one VR chiplet with all 52 phases enabled. The plots 800 and 810 represent data with the output voltage of the VR chiplet at 0.7 V and 1.0, respectively. The plots indicate the net efficiency is higher at higher output voltages and loads and is generally well-behaved.

FIG. 9 depicts example plots of efficiency (plot 900) and load current distribution (plots 910 and 920) versus total load current for the VR chiplets 432 and 434 of FIG. 4, in accordance with various embodiments. The plot 900 is read using the left hand axis and the plots 910 and 920 are read using the right hand axis. The plot 920 is for a VR chiplet which outputs two-thirds (a prescribed ratio) of the current of another VR chiplet represented by the plot 910. The plot 900 indicates the net efficiency of the VR chiplets combined is higher at higher output voltages and is generally well-behaved, even when the VR chiplets have different output currents.

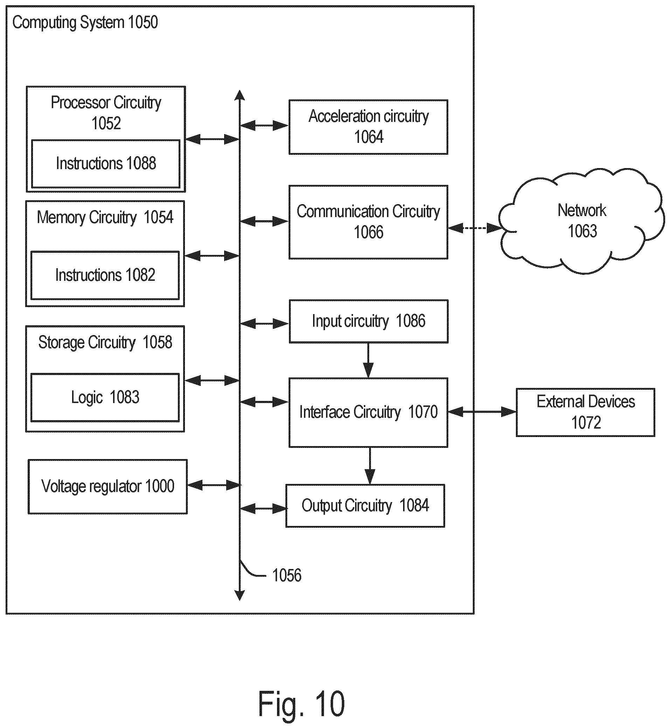

FIG. 10 illustrates an example of components that may be present in a computing system 1050 for implementing the techniques (e.g., operations, processes, methods, and methodologies) described herein.

The computing system 1050 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 1050, or as components otherwise incorporated within a chassis of a larger system. In an example implementation, the voltage regulator 1000 represents one or more of the VR chiplets 230, 332, 432 and 434 as discussed herein, and the other circuitry can represent one or more load die which are powered by the one or more VR chiplet. In one approach, all or part of the computing system 1050 is provided in a SoP, System in Package (SiP) or a System on Chip (SoC).

The voltage regulator can provide a voltage Vout to one or more of the components of the computing system 1050. The memory circuitry 1054 may store instructions and the processor circuitry 1052 may execute the instructions to perform the functions described herein.

The system 1050 includes processor circuitry in the form of one or more processors 1052. The processor circuitry 1052 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 1052 may include one or more hardware accelerators (e.g., same or similar to acceleration circuitry 1064), which may be microprocessors, programmable processing devices (e.g., FPGA, ASIC, etc.), or the like. The one or more accelerators may include, for example, computer vision and/or deep learning accelerators. In some implementations, the processor circuitry 1052 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein.

The processor circuitry 1052 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 1052 may be coupled with or may include memory/storage and may be configured to execute instructions stored in the memory/storage to enable various applications or operating systems to run on the platform 1050. The processors (or cores) 1052 is configured to operate application software to provide a specific service to a user of the platform 1050. In some embodiments, the processor(s) 1052 may be a special-purpose processor(s)/controller(s) configured (or configurable) to operate according to the various embodiments herein.

As examples, the processor(s) 1052 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 1052 may be a part of a system on a chip (SoC), System-in-Package (SiP), a multi-chip package (MCP), and/or the like, in which the processor(s) 1052 and other components are formed into a single integrated circuit, or a single package. Other examples of the processor(s) 1052 are mentioned elsewhere in the present disclosure.

The system 1050 may include or be coupled to acceleration circuitry 1064, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 1064 may comprise logic blocks or logic fabric and other interconnected resources that may be programmed (configured) to perform various functions, such as the procedures, methods, functions, etc. of the various embodiments discussed herein. In such implementations, the acceleration circuitry 1064 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 1052 and/or acceleration circuitry 1064 may include hardware elements specifically tailored for machine learning and/or artificial intelligence (AI) functionality. In these implementations, the processor circuitry 1052 and/or acceleration circuitry 1064 may be, or may include, an AI engine chip that can run many different kinds of AI instruction sets once loaded with the appropriate weightings and training code. Additionally or alternatively, the processor circuitry 1052 and/or acceleration circuitry 1064 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google^{®} Inc., Real AI Processors (RAPs^{™}) provided by AlphaICs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 1052 and/or acceleration circuitry 1064 and/or hardware accelerator circuitry may be implemented as AI accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 or A12 Bionic SoC, the Neural Processing Unit (NPU) within the HiSilicon Kirin provided by Huawei^{®}, and/or the like. In some hardware-based implementations, individual subsystems of system 1050 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 1050 also includes system memory 1054. Any number of memory devices may be used to provide for a given amount of system memory. As examples, the memory 1054 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 1054 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 1054 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 1058 provides persistent storage of information such as data, applications, operating systems and so forth. In an example, the storage 1058 may be implemented via a solid-state disk drive (SSDD) and/or high-speed electrically erasable memory (commonly referred to as "flash memory"). Other devices that may be used for the storage 1058 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 1054 and/or storage circuitry 1058 may also incorporate three-dimensional (3D) cross-point (XPOINT) memories from Intel^{®} and Micron^{®}.

The memory circuitry 1054 and/or storage circuitry 1058 is/are configured to store computational logic 1083 in the form of software, firmware, microcode, or hardware-level instructions to implement the techniques described herein. The computational logic 1083 may be employed to store working copies and/or permanent copies of programming instructions, or data to create the programming instructions, for the operation of various components of system 1050 (e.g., drivers, libraries, application programming interfaces (APIs), etc.), an operating system of system 1050, one or more applications, and/or for carrying out the embodiments discussed herein. The computational logic 1083 may be stored or loaded into memory circuitry 1054 as instructions 1082, or data to create the instructions 1082, which are then accessed for execution by the processor circuitry 1052 to carry out the functions described herein. The processor circuitry 1052 and/or the acceleration circuitry 1064 accesses the memory circuitry 1054 and/or the storage circuitry 1058 over the interconnect (IX) 1056. The instructions 1082 direct the processor circuitry 1052 to perform a specific sequence or flow of actions, for example, as described with respect to flowchart(s) and block diagram(s) of operations and functionality depicted previously. The various elements may be implemented by assembler instructions supported by processor circuitry 1052 or high-level languages that may be compiled into instructions 1088, or data to create the instructions 1088, to be executed by the processor circuitry 1052. The permanent copy of the programming instructions may be placed into persistent storage devices of storage circuitry 1058 in the factory or in the field through, for example, a distribution medium (not shown), through a communication interface (e.g., from a distribution server (not shown)), over-the-air (OTA), or any combination thereof.

The IX 1056 couples the processor 1052 to communication circuitry 1066 for communications with other devices, such as a remote server (not shown) and the like. The communication circuitry 1066 is a hardware element, or collection of hardware elements, used to communicate over one or more networks 1063 and/or with other devices. In one example, communication circuitry 1066 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 1066 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 1056 also couples the processor 1052 to interface circuitry 1070 that is used to connect system 1050 with one or more external devices 1072. The external devices 1072 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 1050, which are referred to as input circuitry 1086 and output circuitry 1084. The input circuitry 1086 and output circuitry 1084 include one or more user interfaces designed to enable user interaction with the platform 1050 and/or peripheral component interfaces designed to enable peripheral component interaction with the platform 1050. Input circuitry 1086 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 1084 may be included to show information or otherwise convey information, such as sensor readings, actuator position(s), or other like information. Data and/or graphics may be displayed on one or more user interface components of the output circuitry 1084. Output circuitry 1084 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 1050. The output circuitry 1084 may also include speakers and/or other audio emitting devices, printer(s), and/or the like. Additionally or alternatively, sensor(s) may be used as the input circuitry 1084 (e.g., an image capture device, motion capture device, or the like) and one or more actuators may be used as the output device circuitry 1084 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 1050 may communicate over the IX 1056. The IX 1056 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 1056 may be a proprietary bus, for example, used in a SoC based system.

The number, capability, and/or capacity of the elements of system 1050 may vary, depending on whether computing system 1050 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 1050 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Some non-limiting examples of various embodiments are presented below.

Example 1 includes an apparatus, comprising: an integrated circuit comprising a voltage regulator; a package interposer coupled to the integrated circuit, wherein the package interposer comprises a set of coaxial inductors coupled to the voltage regulator, and the coaxial inductors extend from a bottom side of the package interposer to a top side of the package interposer; and one or more load die coupled to the set of coaxial inductors.

Example 2 includes the apparatus of Example 1, wherein: the integrated circuit is among a plurality of integrated circuits arranged laterally on the package interposer; the integrated circuits comprise respective voltage regulators; and the package interposer comprises a set of coaxial inductors coupled to the respective voltage regulators.

Example 3 includes the apparatus of Example 2, further comprising a compensator circuit coupled to each voltage regulator of the plurality of integrated circuits to equalize a current output of the voltage regulator with a current output of one or more other voltage regulators.

Example 4 includes the apparatus of any one of Examples 1-3, wherein the voltage regulator comprises a plurality of powertrains and the powertrains are coupled to respective coaxial inductors of the set of coaxial inductors.

Example 5 includes the apparatus of any one of Examples 1-4, wherein each coaxial inductor of the set of coaxial inductors comprises a composite magnetic material surrounding a metal cylinder, and a dielectric core within the metal cylinder.

Example 6 includes the apparatus of any one of Examples 1-5, wherein the integrated circuit comprises a chiplet.

Example 7 includes the apparatus of any one of Examples 1-6, wherein: the integrated circuit, the package interposer and the one or more load die are in a system-on-package; the system-on-package is coupled to a top side of a motherboard; the integrated circuit is coupled to a bottom side of the package interposer; and the one or more load die are coupled to a top side of the package interposer.

Example 8 includes the apparatus of any one of Examples 1-6, wherein: the integrated circuit and the package interposer are in a first system-on-package which is coupled to a bottom side of a motherboard; the one or more load die are in a second system-on-package which is coupled to a top side of the motherboard; and the integrated circuit is coupled to a bottom side of the package interposer.

Example 9 includes the apparatus of any one of Examples 1-6, further comprising a system-on-package comprising the integrated circuit and the package interposer.

Example 10 includes the apparatus of any one of Examples 1-9, wherein the coaxial inductors of the set of coaxial inductors are coupled to the voltage regulator at the bottom side of the package interposer and to the one or more load die at the top side of the package interposer.

Example 11 includes an apparatus, comprising: a package interposer comprising a plurality of sets of inductors; and a plurality of chiplets arranged laterally on the package interposer, wherein the chiplets comprise respective voltage regulators coupled to a respective set of inductors among the plurality of sets of inductors, and the inductors comprise a hollow metal cylinder surrounded by a magnetic material and filled with a dielectric material.

Example 12 includes the apparatus of Example 11, further comprising a load die coupled to the package interposer to receive a combined power output of the plurality of chiplets.

Example 13 includes the apparatus of Example 12, wherein the package interposer, the plurality of chiplets and the load die are in a package interposer which is coupled to a top side of a motherboard.

Example 14 includes the apparatus of Example 12, wherein the package interposer and the plurality of chiplets are in a first system-on-package which is coupled to a bottom side of a motherboard, and the load die is in a second system-on-package which is coupled to a top side of the motherboard.

Example 15 includes the apparatus of any one of Examples 12-14, wherein each inductor of the plurality of sets of inductors comprises a first end at a first side of the package interposer and a second end, opposite the first end, at a second side of the package interposer, the first side faces the plurality of chiplets and the second side faces the load die.

Example 16 includes a chiplet, comprising: a plurality of powertrains; a pulse-width modulation (PWM) generator to provide PWM signals to the plurality of powertrains, wherein the powertrains of the plurality of powertrains are configured to provide a respective current to a respective output node in response to the PWM signals, and a load is coupled to the plurality of powertrains via respective inductors; and a compensation circuit coupled to the load, the respective output nodes and the PWM generator, wherein the compensation circuit comprises respective current sensors coupled to the respective output nodes to obtain a combined current of the plurality of powertrains, and a control circuit to perform a comparison of the combined current and a current provided to the load by another chiplet, and to control the PWM generator based on the comparison.

Example 17 includes the chiplet of Example 16, wherein the compensation circuit is to control the PWM generator to equalize the combined current of the plurality of powertrains with the current provided to the load by the another chiplet.

Example 18 includes the chiplet of Example 16 or 17, wherein the compensation circuit comprises a comparator, an output of the comparator is coupled to the PWM generator, a non-inverting input of the comparator is coupled to a reference voltage, and an inverting input is coupled to a voltage based on a voltage of the load.

Example 19 includes the chiplet of Example 18, wherein to provide the reference voltage, the control circuit is to provide an offset to an initial reference voltage based on a difference between the current provided to the load by the another chiplet and the combined current.

Example 20 includes the chiplet of Example 19, wherein the offset is based on a sum of a scaled down version of the current provided to the load by the another chiplet and an offset current minus the combined current.

Example 21 includes a method, comprising: providing pulse-width modulation (PWM) signals from a PWM generator to a plurality of powertrains, wherein each powertrain of the plurality of powertrains is configured to provide a respective current to a respective output node in response to the PWM signals, and a load is coupled to the plurality of powertrains via respective inductors; obtaining a combined current of the plurality of powertrains; perform a comparison of the combined current and a current provided to the load by another chiplet; and controlling the PWM generator based on the comparison.

Example 22 includes the method of Example 21, further comprising controlling the PWM generator to equalize the combined current of the plurality of powertrains with the current provided to the load by the another chiplet.

Example 23 includes a non-transitory machine-readable storage including machine-readable instructions that, when executed, cause a processor or other circuit or computing device to implement the method of Example 21 or 22.

Example 24 includes an apparatus comprising means to perform the method of Example 21 or 22.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus, comprising:
an integrated circuit comprising a voltage regulator;
a package interposer coupled to the integrated circuit, wherein the package interposer comprises a set of coaxial inductors coupled to the voltage regulator, and the coaxial inductors extend from a bottom side of the package interposer to a top side of the package interposer; and
one or more load die coupled to the set of coaxial inductors.

2. The apparatus of claim 1, wherein:
the integrated circuit is among a plurality of integrated circuits arranged laterally on the package interposer;
the integrated circuits comprise respective voltage regulators; and
the package interposer comprises a set of coaxial inductors coupled to the respective voltage regulators.

3. The apparatus of claim 2, further comprising a compensator circuit coupled to each voltage regulator of the plurality of integrated circuits to equalize a current output of the voltage regulator with a current output of one or more other voltage regulators.

4. The apparatus of any one of claims 1-3, wherein the voltage regulator comprises a plurality of powertrains and the powertrains are coupled to respective coaxial inductors of the set of coaxial inductors.

5. The apparatus of any one of claims 1-4, wherein each coaxial inductor of the set of coaxial inductors comprises a composite magnetic material surrounding a metal cylinder, and a dielectric core within the metal cylinder.

6. The apparatus of any one of claims 1-5, wherein:
the integrated circuit, the package interposer and the one or more load die are in a system-on-package;
the system-on-package is coupled to a top side of a motherboard;
the integrated circuit is coupled to a bottom side of the package interposer; and
the one or more load die are coupled to a top side of the package interposer.

7. The apparatus of any one of claims 1-6, wherein:
the integrated circuit and the package interposer are in first system-on-package which is coupled to a bottom side of a motherboard;
the one or more load die are in a second system-on-package which is coupled to a top side of the motherboard; and
the integrated circuit is coupled to a bottom side of the package interposer.

8. The apparatus of any one of claims 1-7, wherein the coaxial inductors of the set of coaxial inductors are coupled to the voltage regulator the bottom side of the package interposer and to the one or more load die at the top side of the package interposer.

9. A method, comprising:
providing pulse-width modulation (PWM) signals from a PWM generator to a plurality of powertrains, wherein the powertrains of the plurality of powertrains are configured to provide respective currents to a respective output node in response to the PWM signals, and a load is coupled to the plurality of powertrains via respective inductors;
obtaining a combined current of the plurality of powertrains;
perform a comparison of the combined current and a current provided to the load by another chiplet; and
controlling the PWM generator based on the comparison.

10. A non-transitory machine-readable storage including machine-readable instructions that, when executed, cause a processor or other circuit or computing device to implement the method of claim 9.
